# EUROPEAN PATENT APPLICATION

(11) **EP 4 379 806 A1**
(43) Date of publication of application: **05.06.2024**
(21) Application number: 23213791.9
(22) Date of filing: 01.12.2023
(51) Int. Cl.: H01L 29/06, H01L 21/329, H01L 29/861

(54) **HIGH POWER DENSITY RECTIFIER DEVICE**

(30) Priority: 02.12.2022 CN 202211540342
(71) Applicant: Littelfuse Semiconductor (Wuxi) Co., Ltd., Wuxi, Jiangsu 214142 (CN)
(72) Inventor: Zhou, Jifeng, Wuxi, 214142 (CN); Zhang, Glenda, Wuxi, 214142 (CN); He, Lei, Wuxi, 214142 (CN)
(74) Representative: Arnold & Siedsma

(57) **Abstract**

A high power density rectifier diode apparatus, structure and associated methods thereof. The apparatus includes a substrate silicon layer, a middle silicon layer coupled to the substrate layer, an upper silicon layer coupled to the middle silicon layer, a cathode terminal coupled to the substrate silicon layer, an anode terminal coupled to the upper silicon layer, and one or more trench termination layers formed in the substrate silicon layer and at least a portion of the middle silicon layer. The trench termination layers are configured to be formed on at least one side of the substrate silicon layer and at least a portion of the middle silicon layer. The substrate silicon layer is at least one of the following: an n-type layer, a p-type layer, and any combination thereof.

## Description

### TECHNICAL FIELD

This disclosure relates generally to the field of solid state current controlling devices, and in particular, to high power density rectifier devices.

### BACKGROUND

Modern electronics rely on diodes for a variety of functions, and in particular, in power supply applications, such as, for converting an alternating current (AC) into a direct current (DC). A typical rectifier diode is a semiconductor device that includes two leads and allows current to flow in a single direction. The device is manufactured using n-type and p-type semiconductor materials that are joined together via a junction. The n-type semiconductor material in the device forms and is referred to as a cathode side and includes an appropriate cathode lead or terminal. The p-type semiconductor material in the device forms and is referred to as an anode side and includes an appropriate anode lead or terminal. Some existing rectifier diodes suffer from low power output and thus, require a larger chip size to generate sufficient power that may be required for some applications.

### SUMMARY

The following summary is provided to introduce a selection of concepts in a simplified form that are further described below in the detailed description. This summary is not intended to identify key or essential features of the claimed subject matter, nor is it intended as an aid in determining the scope of the claimed subject matter.

In some implementations, the current subject matter relates to a high power density rectifier apparatus. The apparatus may include a substrate silicon layer, a middle silicon layer coupled to the substrate layer, an upper silicon layer coupled to the middle silicon layer, a cathode terminal coupled to the substrate silicon layer, an anode terminal coupled to the upper silicon layer, and one or more trench termination layers formed in the substrate silicon layer and at least a portion of the middle silicon layer.

In some implementations, the current subject matter may include one or more of the following optional features. The substrate silicon layer may be at least one of the following: an n-type layer, a p-type layer, and any combination thereof. The middle silicon layer may be a n-type silicon layer. The middle silicon layer may be a N- silicon layer. The upper silicon layer may be a p-type silicon layer. For example, the upper silicon layer may be a P+ silicon layer.

In some implementations, the middle silicon layer may be configured to be encapsulated in one or more silicon side portions configured to extend from the upper silicon layer.

In some implementations, a p-n junction may be formed between the upper silicon layer and the middle silicon layer.

In some implementations, one or more trench termination layers may include two trench termination layers formed on at least one side of the substrate silicon layer and the at least a portion of the middle silicon layer. At least one portion of each of the one or more trench termination layers may be configured to be substantially parallel to at least one of the following: the substrate silicon layer, the middle silicon layer, the upper silicon layer, the cathode terminal, the anode terminal, and any combination thereof. Further, at least another portion of each of the one or more trench termination layers may be configured to be substantially perpendicular to at least one of the following: the substrate silicon layer, the middle silicon layer, the upper silicon layer, the cathode terminal, the anode terminal, and any combination thereof. In some implementations, a height of at least one of the one or more trench termination layers may be configured to be greater than or equal to a thickness of the substrate silicon layer. Alternatively, or in addition, a height of at least one of the one or more trench termination layers may be configured to be less than or equal to a thickness of the substrate silicon layer.

In some implementations, at least one of the one or more trench termination layers may be configured to extend substantially vertically into the middle silicon layer.

In some implementations, at least one of the one or more trench termination layers may be configured to increase a size of a p-n junction formed between the upper silicon layer and the middle silicon layer. At least one of the one or more trench termination layers may be configured to increase a power density of the apparatus.

In some implementations, the current subject matter relates to a high power density rectifier diode. The diode may include a substrate silicon layer, a middle silicon layer coupled to the substrate layer, an upper silicon layer coupled to the middle silicon layer, a cathode terminal coupled to the substrate silicon layer, an anode terminal coupled to the upper silicon layer, and one or more trench termination layers formed in the substrate silicon layer and at least a portion of the middle silicon layer. The trench termination layers may be configured to be formed on at least one side of the substrate silicon layer and at least a portion of the middle silicon layer. The substrate silicon layer may be at least one of the following: an n-type layer, a p-type layer, and any combination thereof.

In some implementations, the current subject matter relates to a method for manufacturing a high power density rectifier diode. The method may include providing a substrate silicon layer, coupling the substrate layer to a middle silicon layer and coupling the middle silicon layer to an upper silicon layer, coupling a cathode terminal to the first silicon outer layer, and coupling a gate terminal to the first silicon middle layer, coupling a cathode terminal to the substrate silicon layer, and coupling an anode terminal to the upper silicon layer, and forming one or more trench termination layers in the substrate silicon layer and at least a portion of the middle silicon layer.

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the disclosed implementations. In the drawings,
FIG. 1a illustrates an exemplary rectifier diode;
FIG. 1b illustrates an exemplary rectifier diode in a forward-biased state;
FIG. 1c illustrates an exemplary rectifier diode in a reverse-biased state;
FIG. 2a illustrates an exemplary rectifier diode;
FIG. 2b illustrates another exemplary rectifier diode;
FIG. 3 illustrates an exemplary high power density rectifier diode, according to some implementations of the current subject matter; and
FIG. 4 illustrates an exemplary process, according to some implementations of the current subject matter.

The drawings are not necessarily to scale. The drawings are merely representations, not intended to portray specific parameters of the disclosure. The drawings are intended to depict exemplary implementations of the current subject matter, and therefore, are not to be considered as limiting in scope. In the drawings, like numbering represents like elements.

Further, certain elements in some of the figures may be omitted, and/or illustrated not-to-scale, for illustrative clarity. Cross-sectional views may be in the form of "slices", and/or "near-sighted" cross-sectional views, omitting certain background lines otherwise visible in a "true" cross-sectional view, for illustrative clarity. Additionally, for clarity, some reference numbers may be omitted in certain drawings.

### DETAILED DESCRIPTION

Various approaches in accordance with the present disclosure will now be described more fully hereinafter with reference to the accompanying drawings, where implementations of a system and method are shown. The devices, system(s), component(s), etc., may be embodied in many different forms and are not to be construed as being limited to the example implementations set forth herein. Instead, these example implementations are provided so this disclosure will be thorough and complete, and will fully convey the scope of the current subject matter to those skilled in the art.

To address these and potentially other deficiencies of currently available solutions, one or more implementations of the current subject matter relate to methods, systems, articles of manufacture, and the like that can, among other possible advantages, provide a high power density rectifier devices that may be configured to provide an increased power while maintaining the same or smaller than conventional chip size.

As stated above, a rectifier diode is a semiconductor device. One of its purposes is conversion or a rectification of an alternating current (AC) into direct current (DC). A rectifier diode is typically manufactured from silicon, and, in particular, can include one or more layers of silicon stacked upon each other to enable conduction of high electric current. The layers can include p-type and n-type materials that can be chemically combined to form a p-n junction. The p-n junctions can include two terminals or electrodes (e.g., an anode and a cathode).

The rectifier diode can be unbiased (e.g., no voltage is applied), forward-biased and reversed-biased (the latter two resulting from application of voltage to diode's terminals).

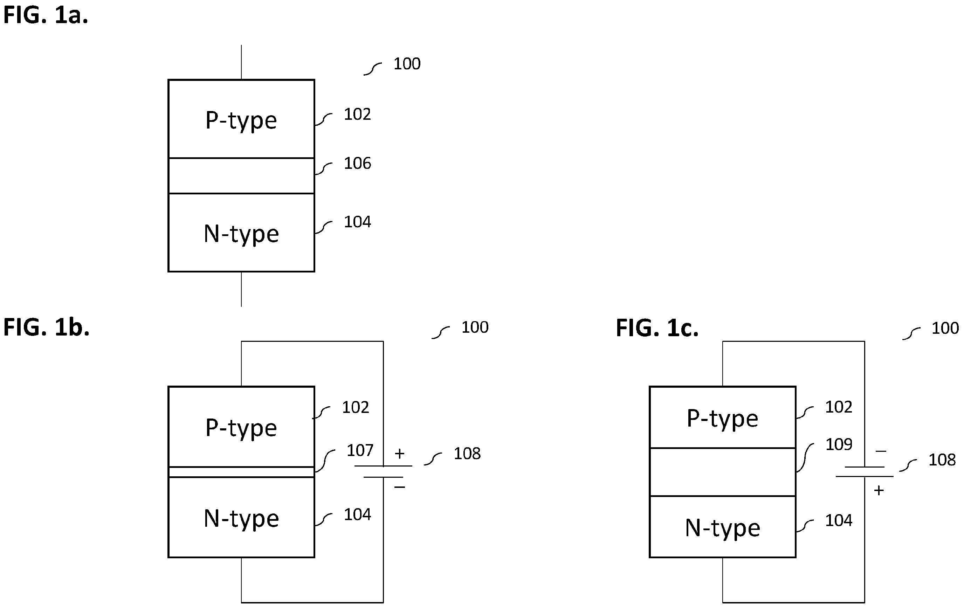

FIG. 1a illustrates an exemplary rectifier diode 100. The rectifier diode 100 includes a p-type layer 102, a n-type layer 104, and a junction 106. As shown in FIG. 1a, no voltage is applied to the rectifier diode 100, resulting in an unbiased rectifier diode. In this case, the n-type layer 104 can include a majority of electrons and few charge carrier holes, and the p-type layer 102 can include a majority of charge carrier holes and few electrons.

Free electrons from the n-type layer 104 can spread into the p-type layer 102 creating immovable positive ions in the n-type layer 104 and immovable negative ions in the p-type layer 102. The immovable positive and negative ions from both sides can concentrate at the junction 106. The junction 106 can also be referred to as a depletion region. A static electrical field can be created across the junction 106, which prevents further migration of electrons across the junction.

FIG. 1b illustrates the exemplary rectifier diode 100 in a forward-biased state. As shown in FIG. 1b, the p-type layer 102 can be coupled to a positive terminal of a battery 108 and the n-type layer 104 can be coupled to a negative terminal of the battery 108. This allows the current flow from the battery 108 through the rectifier diode 100 causing the rectifier diode to become forward-biased.

In this scenario, electrons from the n-type layer 104 can migrate toward the p-type layer 102 (by virtue of being repelled by the n-type layer 104 as a result of the DC voltage from the battery 108). Such electron flow causes the current to flow (or "drift") through the rectifier diode 100. In this case, since majority of the charge carriers are electrons, current in n-type layer 104 is the electron current. Further, because majority of the charge carriers in the p-type layer 102 are holes, these are repelled by the positive terminal of the battery 108, forcing them to migrate across the p-n junction 107 toward the negative terminal. This makes the p-n junction 107 narrower than the p-n junction 106 shown in FIG. 1a.

FIG. 1c illustrates the exemplary rectifier diode 100 in a reverse-biased state. As shown in FIG. 1c, the p-type layer 102 can be coupled to the negative terminal of the battery 108 and the n-type layer 104 can be coupled to the positive terminal of the battery 108. This prevents the current flow (other than reverse saturation current) from the battery 108 through the rectifier diode 100, thereby causing the rectifier diode 100 to become reverse-biased.

In this case, the p-n junction or depletion layer 109 becomes larger than the p-n junction 106 shown in FIG. 1a, thereby increasing the reverse-biased voltage that may be required to overcome this region. A small number of charge carriers (e.g., thermally generated electrons/holes in p-type and n-type layers) may flow through p-n junction 100 and are typically referred to as a saturation current. However, an uncontrolled increase of reverse-biased voltage across the rectifier diode 100 will break the depletion region 109 and destroy the rectifier diode 100.

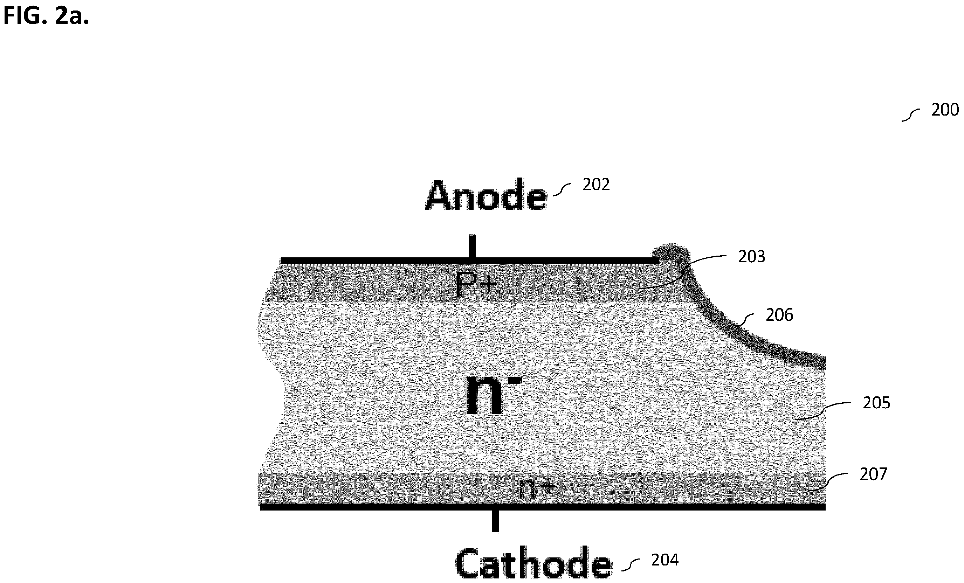

FIG. 2a illustrates an exemplary rectifier diode 200. The rectifier diode 200 includes an anode terminal or electrode 202, a cathode terminal or electrode 204, and a passivation layer 206. The anode terminal 202 can be coupled to a first layer 203. The cathode terminal 204 can be coupled to a third layer 207. A second layer 205 may be configured to be positioned between the first layer 203 and the third layer 207.

The layer 203 can be a silicon P+ layer with a higher doping concentration. The layer 205 can be a N- silicon layer with a low doping concentration. The layer 207 can be a N+ silicon layer with a high doping concentration. In some cases, the layer 207 can be a substrate of a wafer and/or a diffused layer. The layer 203 can be configured to contact the anode 202 as well as the passivation layer 206. The passivation layer 206 can be a thermal oxide that can be formed on top of the layers 203, 205 and a portion of the anode 202.

In some cases, the layer 203 can be formed through selective diffusion of p-type dopants into the layer 205. As such, the layers 203, 205, and 207 can be formed in a substantially parallel manner. A p-n junction can be formed between the P+ layer 203 and the N- layer 205.

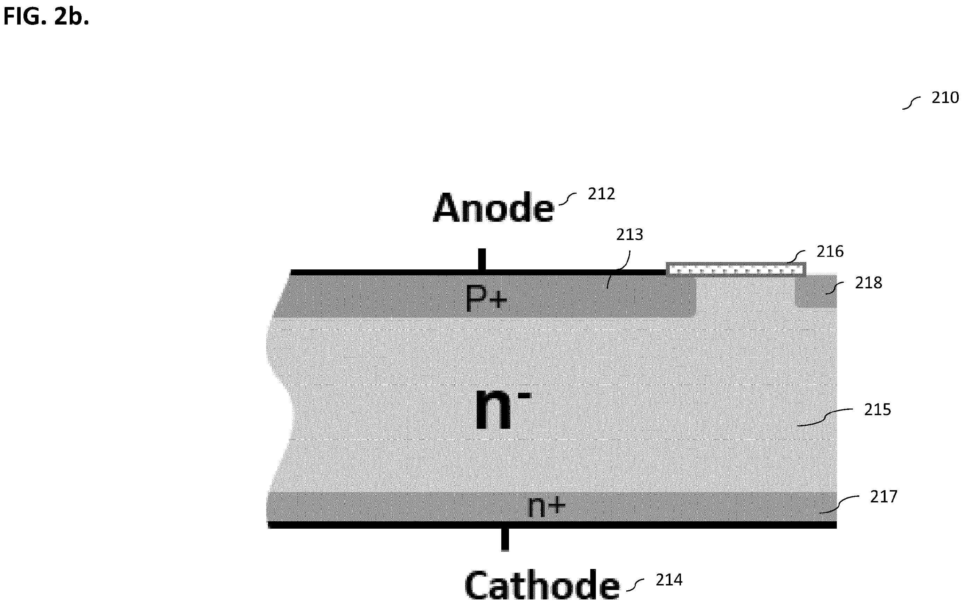

FIG. 2b illustrates an exemplary rectifier diode 210. The rectifier diode 210 includes an anode terminal or electrode 212, a cathode terminal or electrode 214, and a glass passivation layer 216. The anode terminal 212 can be coupled to a first layer 213. The cathode terminal 214 can be coupled to a third layer 217. A second layer 215 may be configured to be positioned between the first layer 213 and the third layer 217.

Additionally, a fourth layer 218 can be incorporated into the second layer 218. The glass passivation layer 216 may be configured to provide a bridge between the layers 213 and 218. The layer 218 is not coupled to the anode terminal 212.

Similar to the rectifier diode 200 shown in FIG. 2a, the layer 213 is a silicon P+ layer with a higher doping concentration. The layer 215 is a N- silicon layer with a low doping concentration. The layer 217 is a N+ silicon layer with a high doping concentration. The layer 218 can be another P silicon layer. In some cases, the layer 218 can provide control of electric field across the p-n junction that is formed between the layers 213 and 215.

Similar to the layer 207 of the rectifier diode 200 shown in FIG. 2a, the layer 217 is a substrate and/or a diffused layer. The layer 213 can contact the anode 212 and the glass passivation layer 216. The anode 212 is formed on top of the P+ layer 213. A portion of the N-layer 215 extends between the P+ layer 213 and the layer 218, but does not contact the anode 212. The glass passivation layer 216 is formed on at least a portion of the P+ layer 213 that extends beyond the anode 212, the portion of the N- layer 215 that extends between the layer 213 and the layer 218, and a portion of the layer 218.

The layers 213 and/or 218 (assuming layer 218 is a P-type layer) are formed using diffusion of p-type dopants into the layer 215. As such, the layers 213, 215, 217, and 218 can be formed in a substantially parallel manner. A p-n junction can be formed between the P+ layer 213 and the N- layer 215, where, as stated above, the layer 218 can be used to control electrical current passing through the device 210.

The rectifier diodes 200 (shown in FIG. 2a) and 210 (shown in FIG. 2b) are examples of conventional rectifier diodes. Such diodes typically suffer from a reduced performance and lower power due to smaller p-n junction. The current subject matter is configured to provide an increased power density, while maintaining a smaller chip size. Such increased power density can be accomplished through a larger p-n junction formed as a result of a novel geometry of the current subject matter's rectifier diode.

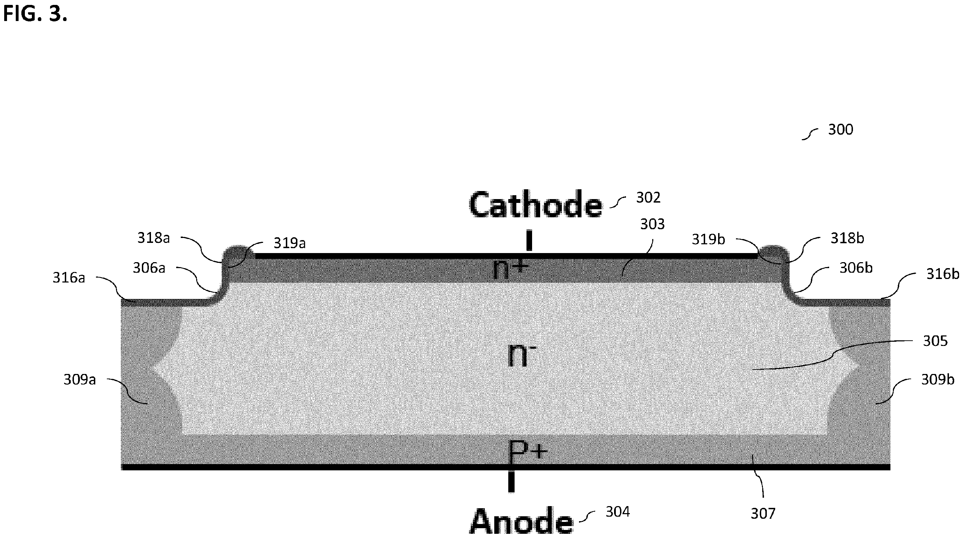

FIG. 3 illustrates an exemplary high power density rectifier diode 300, according to some implementations of the current subject matter. The rectifier diode 300 may include a cathode terminal or electrode 302, an anode terminal or electrode 304, and one or more termination trench portions 306 (a, b). The cathode terminal 302 may be coupled to a first layer 303. The anode terminal 304 may be coupled to a third layer 307. A second layer 305 may be configured to be positioned between the first layer 303 and the third layer 307.

The layer 307 may further include side portions or layers 309 (a, b) that may be configured to enclose the second layer 305. The side portion 309a may be configured to be disposed on a left side of the layer 305. The side portion 309b may be configured to be disposed on a right side of the layer 305. Further, each side portion 309 may be configured to extend between the anode terminal 304 and the respective termination trench portions 306. For example, the side portion 309a may be configured to extend between the anode terminal 304 and the termination trench portion 306a; and the side portion 309b may be configured to extend between the anode terminal 304 and the termination trench portion 306b.

Each termination trench portion 306 may be configured to include a horizontal portion 316 and a vertical portion 318. In particular, the termination trench portion 306a may include a horizontal portion 316a and a vertical portion 318a, and the termination trench portion 306b may include a horizontal portion 316b and a vertical portion 318b. The horizontal portions 316 may be configured to be coupled to top portions of respective side portions 309 as well as portions of the second layer 305. For example, the horizontal portion 316a may be configured to be coupled to the side portion 309a and a portion (on a left side) of the second layer 305, as shown in FIG. 3, and the horizontal portion 316b may be configured to be coupled to the side portion 309b and a portion (on a left side) of the second layer 305.

Further, each vertical portion 318 may be configured to be coupled to a respective side of first layer 303 and a portion of the second layer 305. For instance, the vertical portion 318a may be configured to be coupled to the side portion 319a of the first layer 303 and a portion (on a left side) of the second layer 305, and the vertical portion 318b may be configured to be coupled to the side portion 319b of the first layer 303 and a portion (on a left side) of the second layer 305.

In some implementations, the layers 303-307 may be silicon layers that may have same and/or different doping concentrations. The layers may be of p and/or n type. As shown in FIG. 3, for example, the first layer 303 may be a N+ layer having a higher doping concentration. The layer 305 may be a N- layer with a low doping concentration. The layer 307 may be a P+ layer with a higher doping concentration. In some implementations, the side portions 309 may also be configured as p-type layers. For instance, the side portions 309 may be similar to the layer 307 and may be P+ silicon layers. Alternatively, or in addition, the first layer 303 may be a p-type layer instead of n-type layer, whereby one or more of the other layers 305 and/or 307 may be changed accordingly (if so required by a particular design and/or application).

In some implementations, the first layer 303 may be substrate layer, which may be configured to be positioned on a chip and/or any other circuit board. The layer 303 may be configured to contact the cathode 302 as well as the termination trench portions 306 on one side and the second layer 305 on the other side. The termination trench portions 306 may be configured to reduce a footprint or termination area of the first layer 303 as well as the cathode 302, while, at the same time, increasing a size of the p-n junction that may be formed between the first layer 303 and the second layer 305. This, in turn, may be configured to increase power density of the rectifier diode 300.

Further, the depth (and/or height) of the termination trench portions 306 may be configured to be greater than the thickness of the first layer 303. As shown in FIG. 3 (and as discussed above), the termination trench portions 306 may be configured to extend substantially vertically into the second layer 305. Alternatively, or in addition, the depth (and/or height) of the termination trench portions 306 may be configured to be substantially the same and/or less than the thickness of the first layer 303. As can be understood, the depth (and/or height) of the termination trench portions 306 may be selected in accordance with a particular application and/or use of the rectifier diode 300.

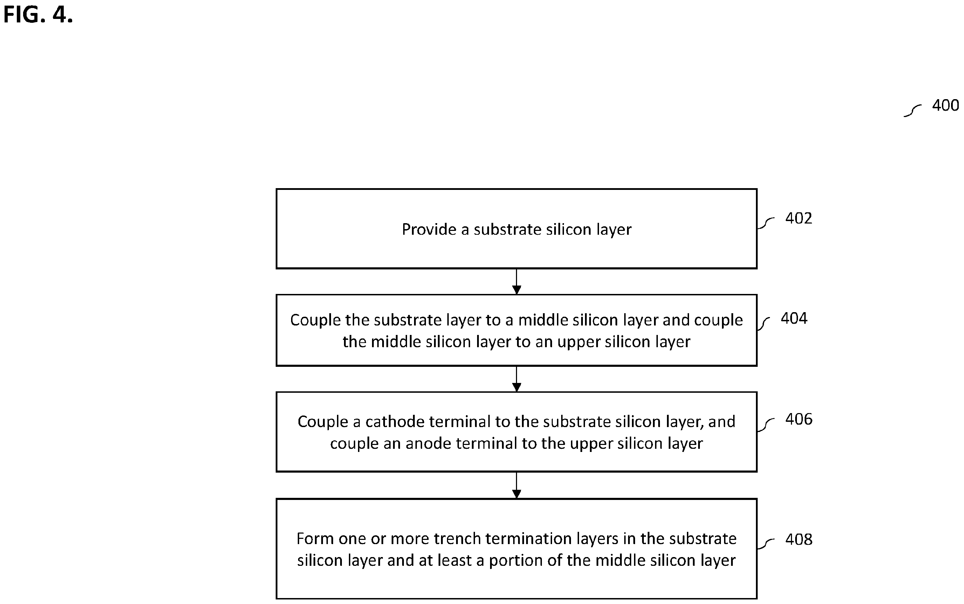

FIG. 4 illustrates an exemplary process 400 for manufacturing a high power density rectifier diode, according to some implementations of the current subject matter. The process 400 may be configured to be used for manufacturing various rectifier diodes, such as, rectifier diode 300 shown in FIG. 3. At 402, a substrate silicon layer may be provided. The substrate silicon layer may be similar to the first layer 303 of the rectifier diode 300 shown in FIG. 3. The substrate layer may be a n-type layer (e.g., N+ silicon layer) and/or p-type layer.

At 404, the substrate layer may be coupled to a middle silicon layer. The middle silicon layer may be similar to the second silicon layer 305 of the rectifier diode 300 shown in FIG. 3. The middle silicon layer may be a N- silicon layer. The middle silicon layer may also be coupled to an upper silicon layer. The upper silicon layer may be similar to the third silicon layer 307 of the rectifier diode 300 shown in FIG. 3. The upper silicon layer may be a P+ silicon layer. The middle silicon layer may also be encapsulated and/or otherwise, enclosed in one or more portions (e.g., side portions 309) that may be configured to extend from the upper silicon layer. The coupling of the upper and middle silicon layers may be configured to form a p-n junction.

At 406, a cathode terminal may be configured to be coupled to the substrate silicon layer. For example, cathode terminal or electrode 302 of the rectifier diode 300 may be coupled to the substrate silicon layer, as shown in FIG. 3. Moreover, an anode terminal may be coupled to the upper silicon layer. As is also shown in FIG. 3, the anode terminal 304 may be coupled to the upper silicon layer (e.g., layer 307).

At 408, one or more trench termination layers may be formed in the substrate silicon layer and at least a portion of the middle silicon layer. As shown in FIG. 3, two trench termination layers 306 may be formed in the first layer 303 and at least a portion of the second layer 305.

The trench termination layers 306 may be formed in such a way that at least a portion of the trench termination layers (e.g., portions 316) may be substantially parallel to one or more of the substrate, middle, and/or upper silicon layers (e.g., layers) 303-305 and/or the cathode and anode terminals. Additionally, at least another portion of the trench termination layers may be substantially perpendicular to one or more of the substrate, middle, and/or upper silicon layers (e.g., layers) 303-305 and/or the cathode and anode terminals.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

Some embodiments may be described using the expression "one embodiment" or "an embodiment" along with their derivatives. These terms mean that a particular feature, structure, or characteristic described in connection with the embodiment is included in at least one embodiment. The appearances of the phrase "in one embodiment" (or derivatives thereof) in various places in the specification are not necessarily all referring to the same embodiment. Moreover, unless otherwise noted the features described above are recognized to be usable together in any combination. Thus, any features discussed separately may be employed in combination with each other unless it is noted that the features are incompatible with each other.

It is emphasized that the abstract of the disclosure is provided to allow a reader to quickly ascertain the nature of the technical disclosure. It is submitted with the understanding that it will not be used to interpret or limit the scope or meaning of the claims. In addition, in the foregoing detailed description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the detailed description, with each claim standing on its own as a separate embodiment. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects. Further, the use of "including," "comprising," or "having" and variations thereof herein is meant to encompass the items listed thereafter and equivalents thereof as well as additional items. Accordingly, the terms "including," "comprising," or "having" and variations thereof are open-ended expressions and can be used interchangeably herein.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the spirit and scope of the appended claims.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

The present disclosure is not to be limited in scope by the specific implementations described herein. Indeed, other various implementations of and modifications to the present disclosure, in addition to those described herein, will be apparent to those of ordinary skill in the art from the foregoing description and accompanying drawings. Thus, such other implementations and modifications are intended to fall within the scope of the present disclosure. Furthermore, the present disclosure has been described herein in the context of a particular implementation in a particular environment for a particular purpose. Those of ordinary skill in the art will recognize the usefulness is not limited thereto and the present disclosure may be beneficially implemented in any number of environments for any number of purposes. Thus, the claims set forth below are to be construed in view of the full breadth and spirit of the present disclosure as described herein.

## Claims

1. An apparatus, comprising:
a substrate silicon layer;
a middle silicon layer coupled to the substrate layer;
an upper silicon layer coupled to the middle silicon layer;
a cathode terminal coupled to the substrate silicon layer;
an anode terminal coupled to the upper silicon layer; and
one or more trench termination layers formed in the substrate silicon layer and at least a portion of the middle silicon layer.

2. The apparatus according to claim 1, wherein the substrate silicon layer is at least one of the following: an n-type layer, a p-type layer, and any combination thereof.

3. The apparatus according to claim 1, wherein the middle silicon layer is a n-type silicon layer.

4. The apparatus according to claim 1, wherein the upper silicon layer is a p-type silicon layer.

5. The apparatus according to claim 1, wherein the middle silicon layer is configured to be encapsulated in one or more silicon side portions configured to extend from the upper silicon layer.

6. The apparatus according to claim 5, further comprising a p-n junction formed between the upper silicon layer and the middle silicon layer.

7. The apparatus according to claim 1, wherein the one or more trench termination layers include two trench termination layers formed on at least one side of the substrate silicon layer and the at least a portion of the middle silicon layer.

8. The apparatus according to claim 7, wherein at least one portion of each of the one or more trench termination layers is configured to be substantially parallel to at least one of the following: the substrate silicon layer, the middle silicon layer, the upper silicon layer, the cathode terminal, the anode terminal, and any combination thereof.

9. The apparatus according to claim 8, wherein at least another portion of each of the one or more trench termination layers is configured to be substantially perpendicular to at least one of the following: the substrate silicon layer, the middle silicon layer, the upper silicon layer, the cathode terminal, the anode terminal, and any combination thereof.

10. The apparatus according to claim 9, wherein a height of at least one of the one or more trench termination layers is configured to be greater than or equal to a thickness of the substrate silicon layer.

11. The apparatus according to claim 9, wherein a height of at least one of the one or more trench termination layers is configured to be less than or equal to a thickness of the substrate silicon layer.

12. The apparatus according to claim 9, wherein at least one of the one or more trench termination layers is configured to extend substantially vertically into the middle silicon layer.

13. The apparatus according to claim 11, wherein at least one of the one or more trench termination layers is configured to increase a size of a p-n junction formed between the upper silicon layer and the middle silicon layer.

14. The apparatus according to claim 13, wherein at least one of the one or more trench termination layers is configured to increase a power density of the apparatus.

15. A method, comprising:
providing a substrate silicon layer;
coupling the substrate layer to a middle silicon layer and coupling the middle silicon layer to an upper silicon layer;
coupling a cathode terminal to the first silicon outer layer, and coupling a gate terminal to the first silicon middle layer;
coupling a cathode terminal to the substrate silicon layer, and coupling an anode terminal to the upper silicon layer; and
forming one or more trench termination layers in the substrate silicon layer and at least a portion of the middle silicon layer.
